# EUROPEAN PATENT SPECIFICATION

(11) **EP 2 738 804 B1**
(45) Date of publication and mention of the grant of the patent: **24.07.2019**
(21) Application number: 13191333.7
(22) Date of filing: 04.11.2013
(51) Int. Cl.: H01L 23/433, H01L 23/373, H01L 23/367

(54) **Flexible thermal transfer strips**
Flexible thermische Übertragungsstreifen
Bandes de transfert thermique flexibles

(30) Priority: 28.11.2012 US 201213687007
(43) Date of publication of application: 04.06.2014
(73) Proprietor: Hamilton Sundstrand Corporation, Windsor Locks, CT 06096-1010 (US)
(72) Inventor: Kilroy, Kevin Donald, Rockford, IL 61108 (US); Miller, Darren L., Loves Park, IL 61111 (US); Wavering, Jeffrey T., Rockford, IL 61109 (US)
(74) Representative: Dehns

(56) References cited:
- DE-A1- 3 212 592
- DE-A1- 3 738 897
- DE-A1- 4 004 457
- US-A- 4 156 458

## Description

### TECHNICAL BACKGROUND

This invention relates generally to the dissipation of thermal energy generated by semiconductor devices, such as memory chips.

### BACKGROUND

Some systems, that include single chip or multi-chip integrated circuit assemblies mounted on a substrate with solder bonds and a cap mounted in close proximity to the backsides of the chips, require cooling.

The high circuit densities in modern integrated circuit semiconductor devices require that the heat generated by their operation be efficiently removed in order to maintain the temperature of the devices within limits that will keep the operating parameters of the devices within predetermined ranges, and also prevent destruction of the device by overheating.

The problems of heat removal are increased when the device is connected to the supporting substrate with solder terminals that electrically connect the device to appropriate terminals on the substrate. In such solder-bonded devices, the heat transfer that can be accomplished through the solder bonds is limited, as compared to back-bonded devices. Cooling of semiconductor devices can be achieved by immersing the devices in a suitable liquid coolant. However, these cooling techniques can result in corrosion of the device and substrate metallurgy, and also present rework problems. Cooling can also be achieved by using a fan to create forced air convection. However, system level requirements sometimes prohibit fan usage due to reliability. Cooling can also be achieved by providing a conducting link of material between the device and the cap or cold plate.

US 4156458 A, DE 4004457 A1, DE 3212592 A1 and DE 3738897 A1 may be useful in understanding the background of the present disclosure.

### SUMMARY

The present invention provides an attachment system for use between a heat generating electronic device having a die having a shape placed thereon and a heat sink, as defined in claim 1.

The strips may include strands only.

The strands may include two or more strands made of copper, silver, aluminum, or graphite.

The strips may include layers only.

The layers may include two or more layers made of copper, silver, aluminum, or graphite.

The frame, the strips, and the slug may comprise a preform.

The present invention further provides an electronic heat sink system for dissipating heat as defined in claim 6.

The strips may include strands only.

The strands may include two or more strands made of copper, silver, aluminum, or graphite.

The strips may include layers only wherein the layers include two or more layers made of copper, silver, aluminum, or graphite.

The electronic heat sink system may further comprise a spring biasing the slug for urging the slug against the die.

The electronic heat sink system may further comprise a die disposed atop the heat generating electronic device between the heat generating electronic device and the slug.

The system may further comprise a thermal layer disposed between the heat generating electronic device and the slug.

The frame, the strips, and the slug may comprise a preform.

The system may further comprise a spring abutting the slug.

The preform may be preattached to either of the heat generating electronic device or the heat sink

These and other features may be best understood from the following drawings and specification.

### BRIEF DESCRIPTION OF THE DRAWINGS

Figure 1 shows a side view of an electronic heat sink system.
Figure 2 shows a side view of the electronic heat sink system of Figure 1 incorporating a spring therein.
Figure 3 shows an attachment system used in the electronic heat sink system of Figures 1 and 2.
Figure 4 shows a top view of the attachment system of Figure 3 through a heat sink used in the electronic heat sink system of Figures 1 and 2.
Figure 5 shows a top view of an embodiment of the attachment system of Figure 3 according to the invention.

### DETAILED DESCRIPTION

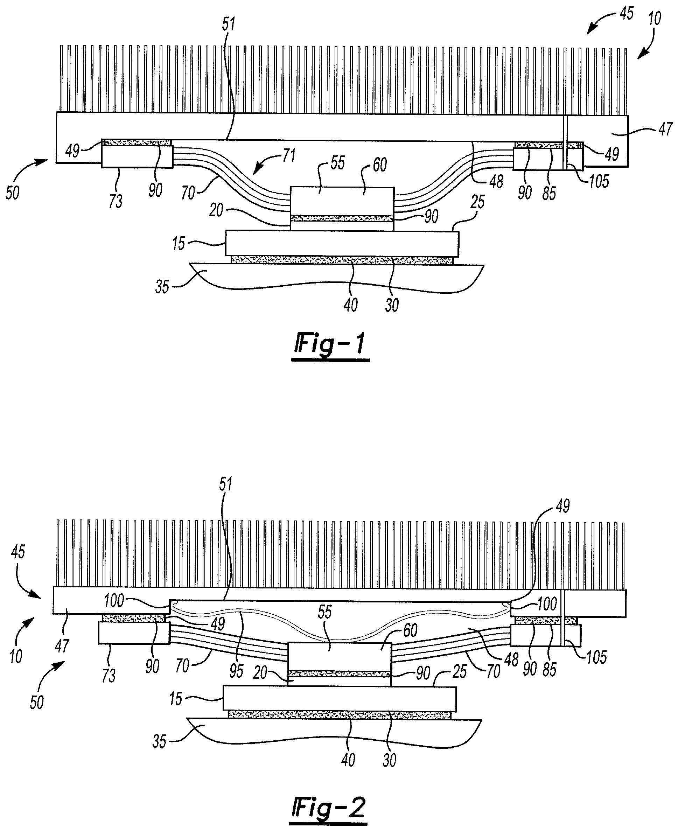

Referring to Figure 1, an electronic heat sink system 10 is shown. A heat generating electronic device such as a microprocessor 15, which has a die 20, which may be non-compressive and thermally conductive, placed on a first surface 25 (i.e., shown as a top surface herein) thereof, also has a second surface 30 (i.e., shown as bottom surface) opposite the first surface 25. The microprocessor 15 may have a plurality of connectors (not shown) attaching thereto as is known in the art. The microprocessor 15 is typically attached to a cold plate 35 by soldering 40 or the like. A heat sink 45 is placed in register with the microprocessor 15. The heat sink has a flat body 47 having a recess 48 therein. The recess 48 has a plurality of radial edges 49 that lead to an inner surface 51 therein. Unless a spring is used, as will be discussed infra, a recess 48 may not be desired.

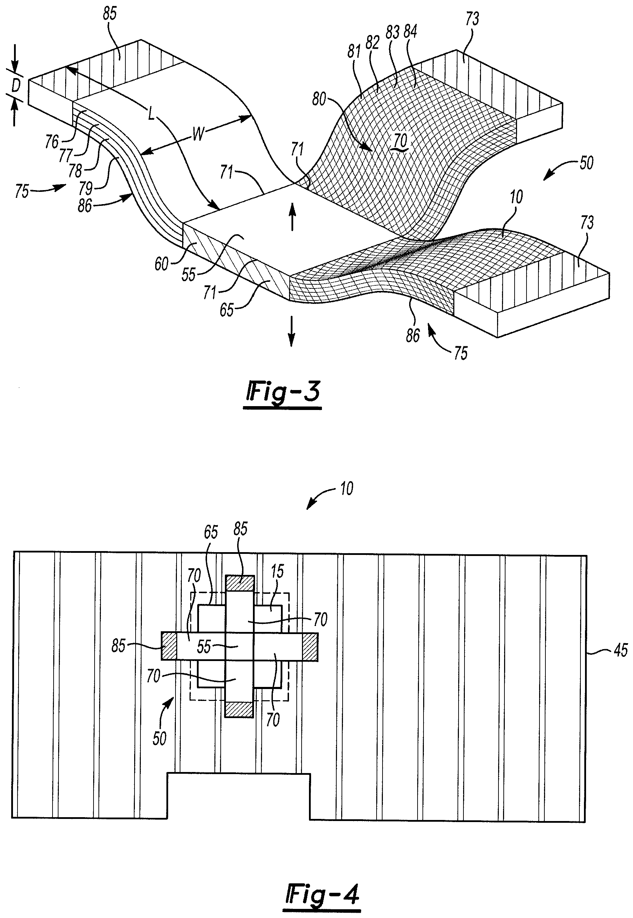

Referring now to Figures 1, 2, and 3, an attachment system 50 for attaching the microprocessor to the heat sink 45 is shown. The attachment system 50 has a thermally conductive slug 55 that has a body 60 that may be made of copper or the like and that is generally rectangular and rigid. The slug 55 can be any shape but generally conforms to the shape of the die 20 of the microprocessor to ensure the efficiency of heat transfer away from the microprocessor 15. As such, if the die 20 is rectangular or other shaped, the body 60 is also rectangular or other shaped. The body 60, in this instance shown, has four side edges 65. Strips 70 are thermally conductive, generally flexible or bendable and have a width W and a length L. Each strip 70 has a proximal edge portion 71 attaching to an edge 65 of the body 60. Each strip has a distal edge portion 73, which may be rigid having a portion 85 facing towards the heat sink 45, and has a depth D. The strip may have a plurality of layers 75, which may be comprised of copper layers 76, silver layers 77, aluminum layers 78, or graphite layers 79. Each strip 70 may also be comprised of braids 80. For instance, the strands of the braids 80 may be a copper strand 81, an aluminum strand 82, a silver strand 83, or a graphite strand 84.

Each strip 70 is non-linear length-wise (e.g., has bends 86) so the strip 70 length L may change as will be discussed infra. Thermal layer 90, which may be an adhesive or grease thermally connects the slug 55 to the die 20.
Each strip 70 may have a particular composition so that each strip acts as a spring to urge the slug 55 against the compressive die 20 to ensure contact between the slug 55 and the die 20. If the electronic heat sink system 10 is to be used in an environment where grease that may be used would not be expected to withstand the vibration experienced in the electronic heat sink system 10, a spring 95, such as a leaf or other spring, may be utilized to ensure that the slug 55 is maintained (i.e., abutting or attaching) against the die 20 in all instances to ensure that thermal transfer is carried out in every instance. It is also possible that the flexible strips 70 do not act as springs, but are flexible/bendable to enable installation where manufacturing and installation tolerances, which may not always be ideal, have to be accounted for during assembly.

To install the attachment system between the microprocessor 15 and the heat sink 45, the slug 55 abuts the die 20 with either a thermal layer 90 of adhesive or grease therebetween. The strips 70 are bent or flexed inwardly or outwardly relative to the slug 55 to the desired length L so that the distal edge portions 73 abut the flat body 47 at a desired location on the heat sink 45. The portions 85 may be attached to the flat body 47 by using a thermal layer 90 such as adhesive therebetween, by mechanical attachment 105 by rivets or nuts and bolts, or both to ensure continued contact with the heat sink 45. The distal edge portion 73 may also be connected to the radial edge 49 and to the inner surface 51 to maximize heat transfer to the heat sink 45.

In an example, included herein for illustration, referring to Figure 2, the portions 85 may be attached to the flat body 47 outside of the recess 48 and the spring 95 is disposed in the recess 48 between the slug 55 and the flat body 47. The spring 95 is in contact with the slug 55 to urge the slug 55 against the die 20. Ends 100 of the spring 95 abut the inner surface 51 and radial edges 49.

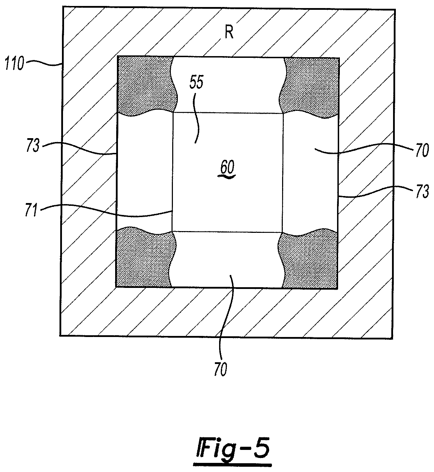

Referring to Figure 5, the distal edge portions 73 are attached to a thermally conductive frame 110. The frame has the same number of sides as there are strips 70. The frame 110 attaches to the flat body 47 either inside or outside of the recess 48. As above, the spring 95 is disposed in the recess 48 between the slug 55 and the flat body 47. The spring 95 is in contact with the slug 55 to urge the slug 55 against the die 20. Ends 100 of the spring 95 abut the inner surface 51 and radial edges 49. The frame 110, the strips 70 and the slug 55 may be preassembled as a preform to ease the assembly operation. The installation of this embodiment is as above. The frame 110 is disposed between the microprocessor 15 and the heat sink 45. The slug 55 abuts the die 20 with either a
thermal layer 90 of adhesive or grease therebetween. The strips 70 are bent or flexed inwardly or outwardly relative to the slug 55 to the desired length L so that the frame 110 abuts the flat body 47 at a desired location on the heat sink 45. The spring 95 may also be disposed between the slug 55 and the heat sink 45. The spring 95 may also be part of the preform by attaching the spring to the slug 55.

The preform may be pre-attached to the die 20 or the heat sink 45.

## Claims

1. An attachment system (50) for use between a heat generating electronic device (15) having a die (20) placed thereon and a heat sink (45), said system (10) comprising;
a thermally conductive slug (55) having a plurality of edges (65); and
a plurality of discrete strips (70), each of said strips (70) having:
a proximal end (71) attached to one of said edges (65) of said thermally conductive slug (55),
a distal end (73) which is rigid for attachment to said heat sink (45),
a flexible portion between said distal end (73) and said thermally conductive slug (55), wherein said strips (70) each comprise two of more discrete layers (75) or strands (81, 82, 83, 84) that create a braid (80),
**characterized by**:
a thermally conductive frame (110) attached to the distal edge portions (73) of said strips (70), said frame (110) having a plurality of sides corresponding to the same number of strips (70), each of said distal edges (73) of said strips (70) attaching to a side of the frame (110).

2. The system (50) of claim 1, wherein said strips (70) comprises strands (81, 82, 83, 84).

3. The system (50) of claim 1 or 2, wherein said strands (81, 82, 83, 84) include two or more strands made of copper, silver, aluminum, or graphite.

4. The system (50) of claim 1, wherein said layers (75) include two or more layers made of copper, silver, aluminum, or graphite.

5. The system (50) of any preceding claim, wherein said frame (110), said strips (70), and said slug (55) comprise a preform.

6. An electronic heat sink system (10) for dissipating heat, said system (10) comprising;
a heat generating electronic device (15);
a heat sink (45); and
the attachment system (50) of any preceding claim being disposed between said heat sink (45) and said electronic device (15).

7. The system (10) of claim 6, further comprising a die (20) disposed atop said heat generating electronic device (15) between said heat generating electronic device (15) and said slug (55).

8. The system (10) of claim 6 or 7, further comprising a thermal layer (90) disposed between said heat generating electronic device (15) and said slug (55).

9. The system (10) of claim 8, wherein said frame (110), said strips (70), and said slug (55) comprise a preform.

10. The system (10) of claim 9, further comprising a spring (95) abutting said slug (55).

## Patentansprüche

1. Anbringungssystem (50) zur Verwendung zwischen einer wärmeerzeugenden elektronischen Vorrichtung (15), die eine darauf platzierte Form (20) und eine Wärmesenke (45) aufweist, wobei das System (10) Folgendes umfasst:
einen thermisch leitfähigen Abschnitt (55), der eine Vielzahl von Kanten (65) aufweist; und
eine Vielzahl von einzelnen Streifen (70), wobei jeder der Streifen (70) Folgendes aufweist:
ein proximales Ende (71), das an einer der Kanten (65) des thermisch leitfähigen Abschnitts (55) angebracht ist;
ein distales Ende (73), das steif ist, zur Anbringung an der Wärmesenke (45) ;
einen flexiblen Teil zwischen dem distalen Ende (73) und dem thermisch leitfähigen Abschnitt (55), wobei die Streifen (70) jeweils zwei oder mehr einzelne Schichten (75) oder Stränge (81, 82, 83, 84) umfassen, die einen Zopf (80) erzeugen,
**gekennzeichnet durch**:
einen thermisch leitfähigen Rahmen (110), der an den distalen Kantenteilen (73) der Streifen (70) angebracht ist, wobei der Rahmen (110) eine Vielzahl von Seiten aufweist, die der gleichen Anzahl an Streifen (70) entspricht, wobei jede der distalen Kanten (73) der Streifen (70) an einer Seite des Rahmens (110) angebracht ist.

2. System (50) nach Anspruch 1, wobei die Streifen (70) Stränge (81, 82, 83, 84) umfassen.

3. System (50) nach Anspruch 1 oder 2, wobei die Stränge (81, 82, 83, 84) zwei oder mehr Stränge beinhalten, die aus Kupfer, Silber, Aluminium oder Graphit gefertigt sind.

4. System (50) nach Anspruch 1, wobei die Schichten (75) zwei oder mehr Schichten beinhalten, die aus Kupfer, Silber, Aluminium oder Graphit gefertigt sind.

5. System (50) nach einem vorhergehenden Anspruch, wobei der Rahmen (110), die Streifen (70) und der Abschnitt (55) eine Vorform umfassen.

6. Elektronisches Wärmesenkensystem (10) zum Ableiten von Wärme, wobei das System (10) Folgendes umfasst:
eine wärmeerzeugende elektronische Vorrichtung (15);
eine Wärmesenke (45); und
das Anbringungssystem (50) nach einem vorhergehenden Anspruch, das zwischen der Wärmesenke (45) und der elektronischen Vorrichtung (15) angeordnet ist.

7. System (10) nach Anspruch 6, ferner umfassend eine Form (20), die auf der wärmeerzeugenden elektronischen Vorrichtung (15) zwischen der wärmeerzeugenden elektronischen Vorrichtung (15) und dem Abschnitt (55) angeordnet ist.

8. System (10) nach Anspruch 6 oder 7, ferner umfassend eine thermische Schicht (90), die zwischen der wärmeerzeugenden elektronischen Vorrichtung (15) und dem Abschnitt (55) angeordnet ist.

9. System (10) nach Anspruch 8, wobei der Rahmen (110), die Streifen (70) und der Abschnitt (55) eine Vorform umfassen.

10. System (10) nach Anspruch 9, ferner umfassend eine Feder (95), die an den Abschnitt (55) anstößt.

## Revendications

1. Système de fixation (50) à utiliser entre un dispositif électronique de génération de chaleur (15) ayant une matrice (20) placée au-dessus et un dissipateur de chaleur (45), ledit système (10) comprenant :
un bouchon thermiquement conducteur (55) ayant une pluralité de bords (65) ; et
une pluralité de bandes discrètes (70), chacune desdites bandes (70) ayant :
une extrémité proximale (71) fixée à un desdits bords (65) dudit bouchon thermiquement conducteur (55),
une extrémité distale (73) qui est rigide pour la fixation audit dissipateur de chaleur (45),
une portion flexible entre ladite extrémité distale (73) et ledit bouchon thermiquement conducteur (55), dans lequel lesdites bandes (70) comprennent chacune deux ou plusieurs couches discrètes (75) ou brins (81, 82, 83, 84) qui créent une tresse (80),
**caractérisée par** :
un cadre thermiquement conducteur (110) fixé aux portions de bord distales (73) desdites bandes (70), ledit cadre (110) ayant une pluralité de côtés correspondants au même nombre de bandes (70), chacun desdits bords distaux (73) desdites bandes (70) se fixant à un côté du cadre (110).

2. Système (50) selon la revendication 1, dans lequel lesdites bandes (70) comprend des brins (81, 82, 83, 84).

3. Système (50) selon la revendication 1 ou 2, dans lequel lesdits brins (81, 82, 83, 84) incluent deux ou plusieurs brins en cuivre, argent, aluminium ou graphite.

4. Système (50) selon la revendication 1, dans lequel lesdites couches (75) incluent deux ou plusieurs couches en cuivre, argent, aluminium ou graphite.

5. Système (50) selon une quelconque revendication précédente, dans lequel ledit cadre (110), lesdites bandes (70), et ledit bouchon (55) comprennent une préforme.

6. Système de dissipateur de chaleur électronique (10) pour la dissipation de chaleur, ledit système (10) comprenant ;
un dispositif électronique de génération de chaleur (15) ;
un dissipateur de chaleur (45) ; et
le système de fixation (50) selon une quelconque revendication précédente étant disposé entre ledit dissipateur de chaleur (45) et ledit dispositif électronique (15).

7. Système (10) selon la revendication 6, comprenant en outre une matrice (20) disposée au-dessus dudit dispositif électronique de génération de chaleur (15) entre ledit dispositif électronique de génération de chaleur (15) et ledit bouchon (55).

8. Système (10) selon la revendication 6 ou 7, comprenant en outre une couche thermique (90) disposée entre ledit dispositif électronique de génération de chaleur (15) et ledit bouchon (55).

9. Système (10) selon la revendication 8, dans lequel ledit cadre (110), lesdites bandes (70), et ledit bouchon (55) comprennent une préforme.

10. Système (10) selon la revendication 9, comprenant en outre un ressort (95) venant en butée contre ledit bouchon (55).
